# EUROPEAN PATENT APPLICATION

(11) **EP 1 288 868 A2**
(43) Date of publication of application: **05.03.2003**
(21) Application number: 02015800.2
(22) Date of filing: 15.07.2002
(51) Int. Cl.: G06T 17/00

(54) **Exploded view automatic creation apparatus, storage media and methods**

(30) Priority: 04.09.2001 JP 2001267862
(71) Applicant: Toyota Caelum Incorporated, Nagoya-shi, Aichi-ken, 460-0008 (JP)
(72) Inventor: Kawai, Motomasa, Nagoya-shi, Aichi-ken, 460-0008 (JP)
(74) Representative: Winter, Brandl & Partner

(57) **Abstract**

An exploded view automatic creation device (1) includes a control device (2), an input device (3), an output device (4), a part shape database (7), and an assembly construction database (8). The part shape database (7) stores a shape data of parts for a product. The assembly construction database (8) stores an assembly construction data and an assembling condition data. The control device (2) creates the exploded view of the product by changing the positioning of the art by moving the part in a disassembling direction determined by the assembling condition data based on the assembly construction data and the assembling condition data.

## Description

### BACKGROUND OF THE INVENTION

### 1. Filed of the Invention

This invention relates to an exploded view automatic creation device, an exploded view automatic creation method and a storage media thereof.

### 2. Description of Related Art

Various computer-aided-design ("CAD") systems are widely available for designing a product, for example automobile parts. Designing products using a CAD system has many advantages over conventional paper-based manual product design. This is in view of the ease of processing and modifying data, the capability to perform simulation, and the ease of searching and reusing previous data.

It may be required to make an instruction manual showing an assembling order for assembling parts based on CAD data created using a CAD system. In general, instruction manuals may typically be made in a division or institution that is independent from the division or institution performing the designing operation using a CAD system. Recently instruction manuals independently made in a former division or institution may also be made using CAD data.

An exploded view is required to be provided on instruction manuals for explaining the procedure for assembling parts step by step. Exploded views have had to be manually created based on CAD data. Thus, the creation of exploded views has been a troublesome task having drawbacks, for example, the excessive time required to create an exploded view and the frequent errors that may occur during the process.

### SUMMARY OF THE INVENTION

It is an object of the present invention to provided an exploded view automatic creation device, an exploded view automatic creation method and a storage media thereof by which an exploded view can be easily created.

The exploded view automatic creation device may be used for creating a design drawing of an objective product with the support of a computer including a storage means for storing shape data of the parts of the objective product. Disassembling condition data necessary for creating the exploded view may also be stored. The device of this invention may also have an exploded view creation means for creating the exploded view of the design drawing by changing the positioning of the parts constructed from the from data based on the disassembling condition data.

According to the present invention, the exploded view creation means creates the exploded view of the design drawing by changing the positioning of the parts constructed from the shape data. This is done based on the disassembling condition data which is stored in the storage means.

According to a further aspect of the invention, the disassembling condition data further includes an assembly construction data showing the relationship among each part and a disassembling direction condition data showing the moving direction of the parts when being disassembled. It is preferable that the exploded view creation means creates the exploded view by changing the positioning of the parts in a disassembling direction which is determined by the disassembling direction condition data.

With this construction, the exploded view is created by changing the positioning of the parts in the disassembling direction which is determined by the disassembling direction condition data based on the assembly construction data and the disassembling direction condition data by the exploded view creation means.

According to a still further aspect of the invention, the disassembling direction condition data corresponds to an assembling condition data that is input as an assembling condition for assembling the parts when creating an assembly drawing of the design drawing. It is preferable that the exploded view creation means creates the exploded view by changing the positioning of the parts based on the assembling condition data.

With this construction, the exploded view creation means creates the exploded view by changing the positioning of the parts based on the assembling condition data input as the assembling condition when creating the assembly drawing of the design drawing. Accordingly, because the exploded view is created based on the assembling condition data, a new data for creating the exploded view is not required, and thus it is not necessary to input a new data regarding the exploded view creation.

It is another object of the present invention to provide an exploded view automatic creation method for creating the design drawing regarding an objective product with the support of a computer, in which shape data of the parts regarding the objective product and a disassembling condition data necessary for creating the exploded view is stored in the storage means. An exploded view creation means creates the exploded view of the design drawing by changing the positioning of the parts constructed from the shape data based on the disassembling condition data.

With this method, the shape data of the parts of the objective product and the disassembling condition data necessary for creating the exploded view are stored in the storage means. The exploded view is created by changing the positioning of the parts constructed from the shape data based on the disassembling condition data. Thus, the exploded view is automatically created when providing the assembling operation instruction manual for the objective product and the exploded view can be obtained easily without troublesome drawing operation.

It is still another object of the present invention to provide a storage media which is readable by the computer and includes a program for performing a procedure. The procedure includes the steps for reading-in the shape data of the parts of an objective product and the disassembling condition data necessary for creating the exploded view to be stored in the storage means by the computer. This data is necessary for creating the exploded view of the design drawing of the objective product by changing the positioning of the parts constructed from the shape data. This is done by the computer based on the disassembling condition data, and by outputting the exploded view to an output means.

With this storage media, the shape data of the parts of the objective product and the disassembling condition data necessary for creating the exploded view are stored in the storage means. The exploded view of the design drawing regarding the objective product is created by changing the positioning of the parts constructed from the shape data based on the disassembling condition data in accordance with an exploded view creation command. The exploded view is outputted to the output means. Thus, the exploded view is automatically created when providing an assembling operation instruction manual regarding the objective product. Accordingly, the exploded view can be easily obtained without bothersome drawing operation.

These and other features and advantages of this invention are described in or are apparent from the following detailed description of preferred embodiments.

### BRIEF DESCRIPTION OF THE DRAWINGS

Various exemplary embodiments of the invention will be described with reference to the accompanied drawings, in which like elements are labeled with like numbers and in which:
Fig. 1 shows an overview of an exploded view automatic creation device according to an embodiment of the present invention;
Fig. 2 shows a typical CAD drawing of a product after being assembled which is displayed on a display;
Fig. 3 shows an input screen view of assembly construction data;
Fig. 4 shows an input screen view of assembling condition data;
Fig. 5 shows an explanatory view concerning the assembling condition data;
Fig. 6 shows a screen view displaying an assembly drawing of a product;
Fig. 7 shows a screen view specifically showing one unit of a product;
Fig. 8 shows a screen view displaying an exploded view of the unit of Fig. 7;
Fig. 9 shows another screen view displaying the exploded view of the unit of Fig. 7; and
Fig. 10 shows a flowchart of the steps performed when creating the exploded view.

### DESCRIPTION OF THE PREFERRED EMBODIMENTS

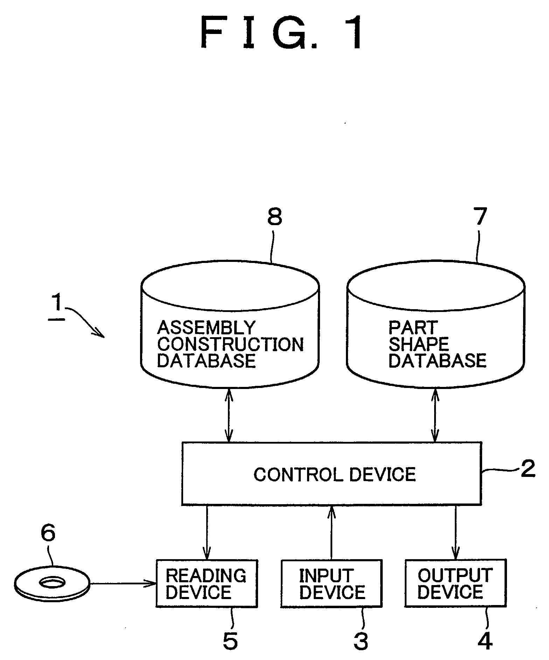

An exploded view automatic creation device 1 shown in Fig. 1 may be used for creating a design drawing of a product which has been drawn by CAD. The exploded view automatic creation device 1 includes a control device 2 serving as an exploded view creation means, an input device 3 serving as an input means, and an output device 4 serving as an output means. The control device 2 creates a drawing regarding the product based on the literal information and the drawing information of drawing figure input from the input device 3. The drawing is outputted from the output device 4 in a proper manner. The control device 2 may comprise a CPU, a ROM, a RAM, etc. The input device 3 may comprise a keyboard, a pointing device, etc. The output device 4 may comprise a display, a printer, etc.

The exploded view automatic creation device 1 further comprises a reading device 5 for reading an exploded view automatic creation program as a program written in a CD-ROM 6 which serves as a storage media to be installed in a hard disc (not shown). The control device 2 creates a CAD drawing such as an assembly drawing, exploded view and the like as a design drawing of the product based on the exploded view automatic creation program.

The exploded view automatic creation device 1 may further comprise a parts shape database 7 and an assembly construction database 8 serving as storage means in which various data is stored using the input device 3. The parts shape database 7 stores shape data (i.e., three-dimensional data) of a part corresponding to a minimum assembly unit of the product. The assembly construction database 8 stores various data (i.e., assembly construction data, assembling condition data) for determining the relationship between each part. The assembly construction data determines which mating part is assembled to a predetermined part.

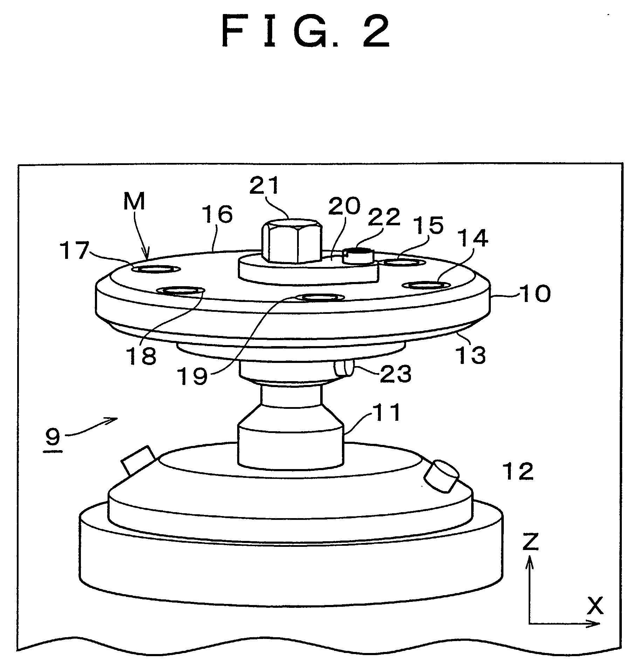

Fig. 2 shows a CAD drawing of a product after assembling which is displayed on a display. The assembly drawing 9 of a product M constructed as a CAD drawing is produced by three-dimensional CAD data, which is constructed based on the shape data of the part input by a user as a structural element of the product M. That is, the assembly drawing 9 of the product M shown in Fig. 2 is constructed by assembling the shape data of each part to a predetermined position by a predetermined procedure. A viewing direction of the CAD drawing of the product M can be freely predetermined.

The product M includes a unit 10, a unit 11, and a unit 12 as a structural element of a highest level. One part is constructed by assembling the unit 10 and the unit 12 on the unit 11. The unit 10 includes parts 13-23 (11 parts in total). One part is constructed by assembling the parts 13-23. Although the unit 11 and the unit 12 are also constructed with a plurality of parts respectively, the explanation of the constructions thereof is omitted.

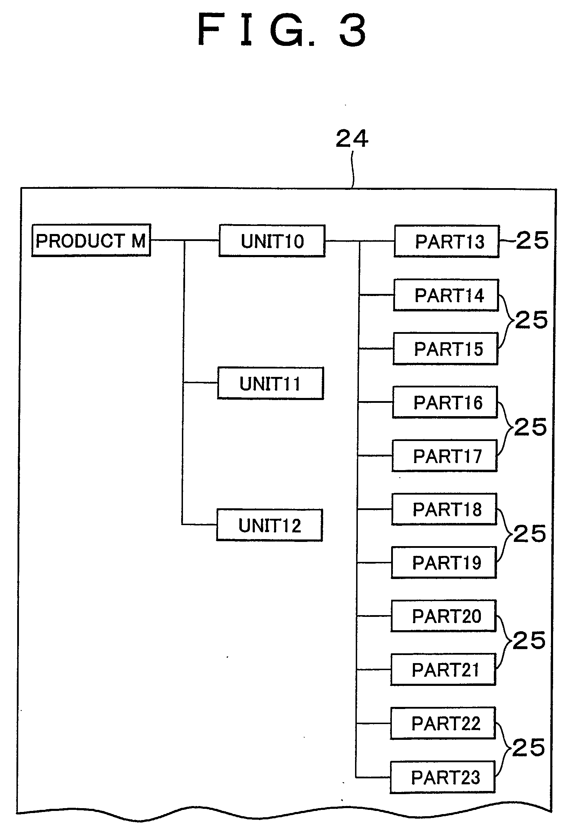

The procedure for constructing the assembly drawing 9 of the product shown in Fig. 2 will be explained as follows. First, the shape data of the product M is constructed as a design drawing. While constructing the shape data, the assembly construction data of the parts is input. In this embodiment, the assembly construction data is input by displaying an input screen 24 shown in Fig. 3, on the display and by constructing tree structure data. Thus, it is predetermined that the product M includes three units 10-12 as a first level and the unit 10 includes the parts 13-23 as a structural element. The shape data is stored in the part shape database 7 and the assembly construction data is stored in the assembly construction database 8.

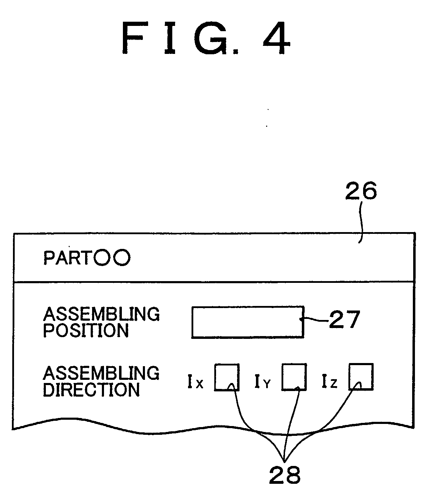

By clicking each button 25 corresponding to the parts 13-23 on the input screen 24, the assembling condition data of each part may then be input by further displaying an input screen 26 shown in Fig. 4. The input screen 26 includes a space 27 for inputting the assembling position (i.e., reference position) and a space 28 for inputting the assembling direction (i.e., three-dimensional direction). The assembling condition data corresponds to the disassembling direction condition data.

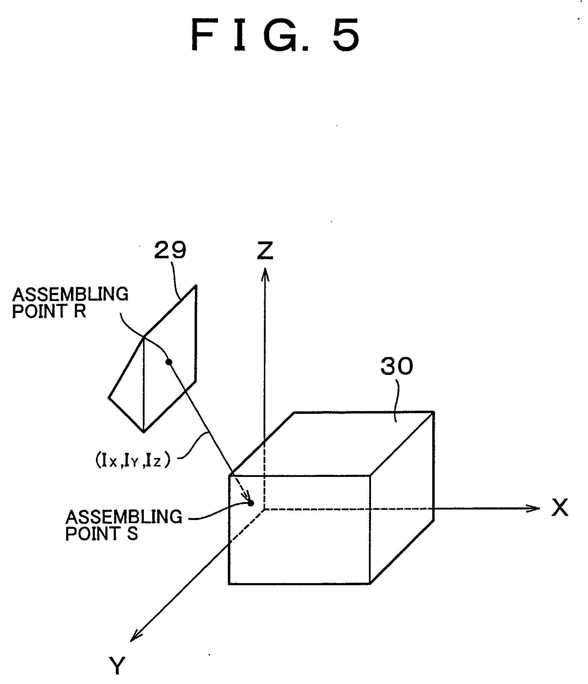

The assembling condition data input is explained referring to Fig. 5. An assembling point R of the part 29 and an assembling point S of a part 30 are input in the space 27 to specify which portion of the part which is to be input (i.e., part 29 of Fig. 5) is assembled to which portion of a mating part (i.e., part 30 of Fig. 5). In this case, the part 29 and the part 30 are assembled by moving the part 29 relative to the part 30 as a reference.

The assembling direction (i.e., Ix, Iy, Iz) of the part 29, that is the angle relative to an X axis, a Y axis, and a Z axis, is input to the space 28 respectively as the assembling direction to the part 30 for specifying the assembling direction of the part 29 relative to the part 30. The assembling condition data is stored in the assembly construction database 8. The assembly construction data input on the input screen 24 and the assembling condition data input in the spaces 27, 28 construct the disassembling condition data.

When the input of the shape data of the part, the assembly construction data, and the assembling condition data is completed for all parts, an exploded view construction mode of the product M is carried out. The control device 2 assembles the parts according to the assembling procedure determined by the assembly construction data and the assembling condition data to construct the assembly drawing 9 of the product M of Fig. 2. That is, each unit 10-12 is individually created by assembling the parts 13-23 which corresponds to the lowest level, then, the units 10-12 are assembled at the next stage to construct the assembly drawing 9 shown in Fig. 2.

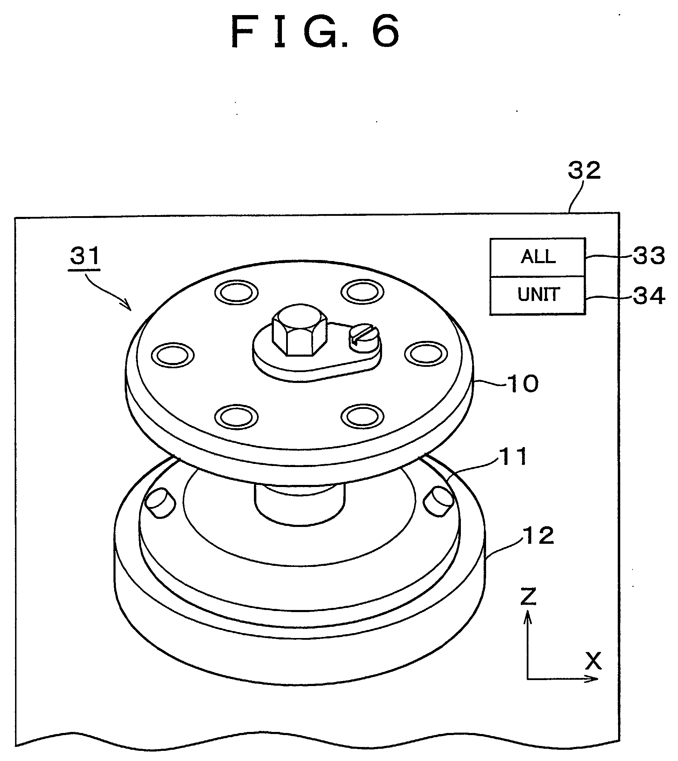

The procedure for constructing the exploded view from the assembly drawing 9 of the product M shown in Fig. 2 will be explained as follows. First, the viewing direction (i.e. angle) of the CAD drawing which corresponds to the assembly drawing of the product M is specified. In this embodiment, a perspective view 31 which is inclined by about 30 degrees with respect to the Z-axis shown in Fig. 6 is specified as the viewing direction. While specifying the viewing direction, a distance between each part and mating part thereof when disassembling is also specified.

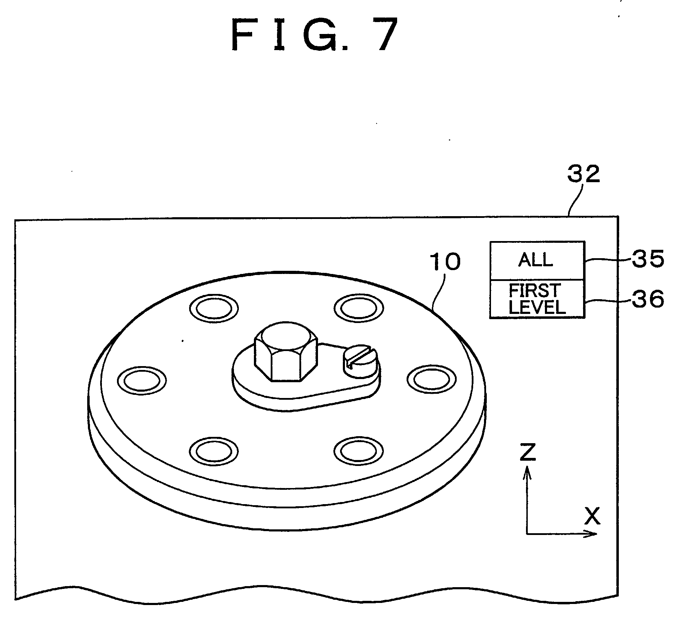

The procedure for specifying the object to be disassembled is performed during the specification transaction. That is, when specifying the object to be disassembled, an "ALL" button 33 and a "UNIT" button 34 are displayed on a display screen 32 of Fig. 6. When the ALL button 33 is clicked, the entire product becomes the object to be disassembled. However, when the "UNIT" button 34 is clicked while clicking the unit whose exploded view is to be constructed on the display, the specified unit becomes the object to be disassembled. According to this embodiment, the unit 10 is specified as the object to be disassembled as shown in Fig. 7 and thus only the unit 10 is displayed on the display screen 32.

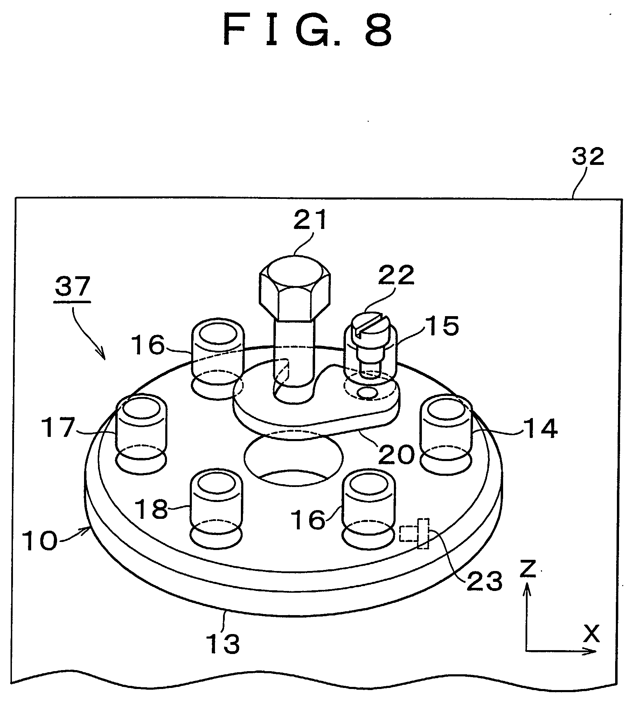

After the specification transaction, an "ALL" button 35 and a "FIRST LEVEL" button 36 are displayed on the display screen 32 of Fig. 7. When the "ALL" button 35 is clicked, the control device 2 creates the exploded view in which the object to be disassembled is disassembled into a part unit which corresponds to the minimum construction unit. When the first level button 36 is clicked, the control device 2 creates the exploded view in which the object to be disassembled is disassembled to the first level. Because the lower level of the unit 10 corresponds to the lowest level, according to this embodiment, the same exploded view is created when selecting both the "ALL" button 35 and the first level button 36. Thus, an exploded view 37 shown in Fig. 8 is displayed on the display screen 32 as a finalized exploded view.

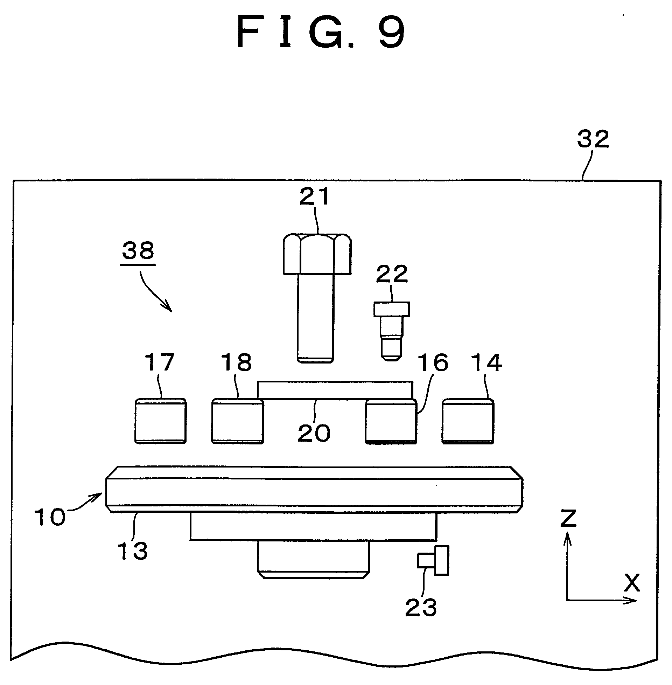

That is, the control device 2 creates the exploded view 37 by changing the positioning of the parts displayed on the display based on the assembly construction data and the assembling condition data. The exploded view 37 is created by performing the transaction for moving each part (i.e., the part 29 of Fig. 5) in an opposite direction (i.e., disassembling direction) against the assembling direction relative to a reference part (i.e., the part 30 of Fig. 5). The exploded view 37, according to this embodiment, is constructed by moving the parts 14-20 in +Z direction relative to the part 13, by moving the parts 21, 22 in +Z direction relative to the part 20, and by moving the part 23 in +X direction relative to the part 13. When a side view is specified as the viewing direction of the CAD drawing of the product M, an exploded view 38 shown in Fig. 9 is created.

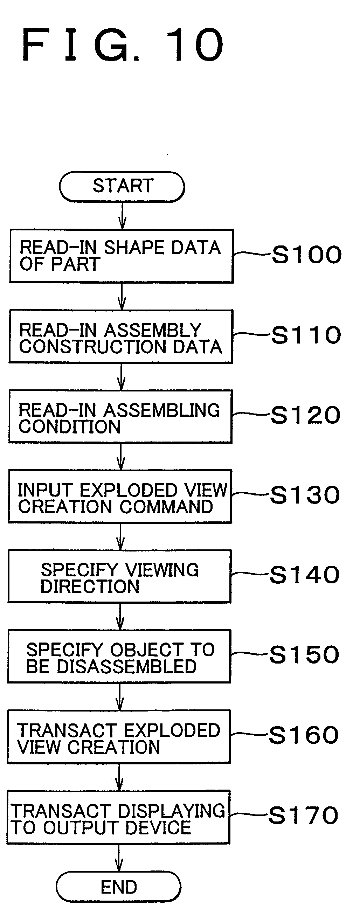

The procedure carried out along the exploded view creation program by the control device 2 when creating the exploded view is explained with respect to the flowchart shown in Fig. 10. First, in Step S100, the shape data of the part is read-in. That is, the shape data regarding the part input by the user is read-in from the part shape database 7. In Step S110, the assembly construction data is read-in . That is, the assembly construction data showing the relationship between the parts specified by the user is read-in from the assembly construction database 8.

In Step S120, the assembling condition is read-in . That is, the relationship between the part specified by the user and the parts is read-in from the assembly construction database 8. In Step S130, the exploded view creation command is input. That is, the drawing creation mode is determined to be the exploded view creation mode. In Step S140, the viewing direction of the exploded view is specified. That is, by specifying the viewing direction of the assembly drawing on the display by the user, the viewing angle of the finalized exploded view is determined.

In Step S150, the object to be disassembled is specified. That is, when the "ALL" button 33 shown on the display is selected, the entire product is specified. When the "UNIT" button 34 is selected, a certain unit is specified as the object to be disassembled. When the "ALL" button 35 shown on the display is selected in the next stage, the entire object is specified as the object to be disassembled. When the "FIRST LEVEL" button 36 is selected, the selected object up to the first level is specified as the object to be disassembled.

In Step S160, the exploded view creation transaction is carried out. That is, the exploded view 37 is created by moving each part to the position determined by the assembling condition data based on the assembly construction data and the assembling condition data. In Step S170, a displaying transaction to the output device 4 is carried out. That is, the exploded view 37 is displayed on the display and is outputted to be printed from the printer. The user operates the input device 3 in accordance with the necessity to move a part to a desired position and also provides a description of the part.

It may be required to provide an instruction manual for the assembling operation regarding the product M. According to the embodiment of the present invention, the instruction manual for the assembling operation can be created using CAD data by assembling the parts constructed from the shape data following the assembling condition database on the positional relationship of the assembly construction data by the control device 2. With this manner, the instruction manual for the assembling procedure regarding the product M can be provided as the instruction manual for the operators who are producing the product M at the plant. Further, whether the design drawing of the product M is accurately created is confirmed with respect to this construction.

An exploded view may be required in a production plant for replacing a malfunctioning part during maintenance of the product M. According to this embodiment of the present invention, the exploded view 37 is created by changing the positioning of the part by moving the parts in the direction determined by the assembling condition data based on the assembly construction data and the assembling condition data by the control device 2. The exploded view 37 may be provided as an instruction manual for the assembling operation. Thus, the exploded view 37 for the design drawing of the product M is automatically created and a user can easily obtain the exploded view 37 when replacing the parts.

Accordingly, the following effects can be obtained with respect to this embodiment. (1) The exploded view 37 is created as the instruction manual for the assembling operation of the product M by moving the position of the part constructed from the shape data in a predetermined disassembling direction based on the assembly construction data and the assembling condition data by the control device 2. Accordingly, the operator (i.e., user) can automatically create the exploded view 37 based on the support by the computer and can obtain the exploded view 37 easily when replacing the parts for the maintenance of the product M. (2) The control device 2 creates the assembly drawing 9 by assembling the parts constructed from the shape data following the assembling condition data based on the positional relationship of the assembly construction data. Thus, the assembling procedure of the product M can be provided to the operators who produce the product M based on the support of the computer. In addition, by providing the instruction manual for the assembling operation, the operator can confirm the design of the product M.

(3) According to the foregoing embodiment of the present invention, the assembling condition data used when constructing the product M is used as the data necessary for constructing the exploded view 37. Thus, when creating the exploded view 37, new data for creating the exploded view is not necessary. Moreover, because the three-dimensional direction is input as the assembling direction to the assembling condition data, the exploded view 37 can be constructed by three-dimensional CAD.

(4) With respect to the embodiment of the present invention, because the entire product of the product M or the individual units 10-12 are selected as the object to be disassembled, the disassembled object can be freely changed and the exploded view can be created in accordance with the specification.

The present invention is not limited to the foregoing embodiment and can be varied as follows. The disassembling condition data is not limited to be constructed with the assembly construction data and the assembling condition data. The content of data is not limited as long as it is used as the data necessary for creating the exploded view for the design drawing. For example, although the three-dimensional assembling direction is input as the disassembling direction in the foregoing embodiment, the assembling direction may be two dimensional or one dimensional as occasion demands.

The disassembling direction condition data is not limited to the assembling condition data. For example, a new data may be input for creating the exploded view 37 of the product M and this input data may be determined as the disassembling direction condition data. The assembling condition data specified as the assembling condition data is not limited to the data input to the input screen 26 shown in Fig. 4. The content of the data is not limited as long as the data is required for creating the exploded view 37.

The input form of the assembly construction data and the assembling condition data is not limited to the embodiment of the present invention. In this case, the assembly construction data is not limited to be input in tree structure. For example, the data input may be performed by adding the assembly construction data to the shape data while inputting the shape data of the parts. Likewise, the assembling condition data may be input while inputting the shape data without opening the input screen 26.

The object to be disassembled is not limited to be the entire product M or the single unit. For example, the user may specify a single or a plurality of the parts to be disassembled using the control device 2 and may create the exploded view of only the selected part or selected parts. The system for constructing the design drawing is not limited to the CAD system. The system can be freely selected as long as it is capable of designing a drawing based on the support of the computer.

The storage media is not limited to the CD-ROM 6. Other media such as a floppy disc and the memory card may be applied. The object of the design drawing is not limited to the product M of the foregoing embodiment. The exploded view automatic creation device 1 of the foregoing embodiment is available for creating design drawings of the various products such as automotive parts, electrical appliances, machine tools, toys, etc. As described above, according to the exemplary embodiments of the present invention, the exploded view may be easily constructed when providing design drawings of a designing object.

While the invention has been described with reference to preferred embodiments thereof, it is to be understood that the invention is not limited to the preferred embodiments or constructions. To the contrary, the invention is intended to cover various modifications and equivalent arrangements. In addition, while the various elements of the preferred embodiments are shown in various exemplary combinations and configurations, other combinations and configurations, including more, less or only a single element, are also within the spirit and scope of the invention.

## Claims

1. An exploded view automatic creation device (1) for creating a design drawing of an objective product, **characterized in that**
the exploded view automatic creation device (1) comprises a storage means (7, 8) for storing shape data of a part for the objective product and disassembling condition data necessary for creating an exploded view and an exploded view creation means (2) for creating the exploded view of the design drawing by changing a positioning of the part constructed from the shape data.

2. An exploded view automatic creation device according to Claim 1, **characterized in that** the disassembling condition data further comprises an assembly construction data showing a relationship between each part and a disassembling direction condition data showing a moving direction of the part when being disassembled, and that the exploded view creation means (2) creates the exploded view by changing the positioning of the part in a disassembling direction which is determined by the disassembling direction condition data based on at least one of the assembly construction data and the disassembling direction condition data.

3. An exploded view automatic creation device according to Claim 2, **characterized in that** the disassembling direction condition data includes an assembling condition data that is input as an assembling condition for assembling the part when creating an assembly drawing of the design drawing, and that the exploded view creation means (2) creates the exploded view by changing the positioning of the part based on the assembling condition data.

4. An exploded view automatic creation method for creating an exploded view of a design drawing for an objective product with a computer, **characterized in that** comprises the steps of
storing a shape data of a part for the objective product and a disassembling condition data necessary for creating an exploded view; and
changing a positioning of a part to be constructed from the shape data based on the disassembling condition data.

5. An exploded view automatic creation method according to Claim 4, **characterized in that** the disassembling condition data further comprises an assembly construction data showing a relationship between each part and a disassembling direction condition data showing a moving direction of the part when disassembled, and that the exploded view is created by changing the positioning of the part in a disassembling direction which is determined by the disassembling direction condition data based on the assembly construction data and the disassembling direction condition data.

6. An exploded view automatic creation method according to Claim 5, **characterized by** further comprising: including an assembling condition data input as an assembling condition for assembling the part when creating an assembly drawing of the design drawing in the disassembling direction condition data; and creating the exploded view by changing the positioning of the part based on the assembling condition data.

7. A method for storing a program using a storage media readable by a computer for creating a design drawing of an objective product with a computer, **characterized by** comprising the step of:
reading-in a shape data of a part for an objective product and a disassembling condition data necessary for creating an exploded view and storing the shape data and the disassembling condition data to a storing means (7, 8) by the computer;
creating the exploded view of the design drawing for the objective product by changing a positioning of a part constructed from the shape data based on the disassembling condition data by the computer in response to an exploded view creation command; and
outputting the exploded view to an output means by the computer.

8. A method for storing a program according to Claim 7, **characterized by** further comprising:
showing a relationship between parts and a disassembling direction condition data showing a moving direction of the part when being disassembled using assembly construction data contained within the disassembly condition data.

9. A method for storing a program according to Claim 8, **characterized by** further comprising:
inputting assembling condition data as an assembling condition for assembling a part when creating an assembly drawing of the design drawing.

10. A method for storing a program according to Claim 9, **characterized in that** the assembling condition data forms part of the disassembling direction condition data.

11. A storage media readable by a computer, **characterized by** comprising a program capable of performing the method of Claim 7.
